# EUROPEAN PATENT APPLICATION

(11) **EP 4 682 959 A1**
(43) Date of publication of application: **21.01.2026**
(21) Application number: 23927232.1
(22) Date of filing: 25.12.2023
(51) Int. Cl.: H01L 31/05, H01L 31/048, H01L 31/18

(54) **PHOTOVOLTAIC CELL PACK, MANUFACTURING METHOD THEREFOR, AND PHOTOVOLTAIC MODULE**

(30) Priority: 13.03.2023 CN 202310233486
(71) Applicant: Trina Solar Co., Ltd, Changzhou, Jiangsu 213031 (CN)
(72) Inventor: GAO, Jifan, Hangzhou, Jiangsu 213031 (CN); XU, Ye, Hangzhou, Jiangsu 213031 (CN); TIAN, Guorong, Hangzhou, Jiangsu 213031 (CN); XU, Jianmei, Hangzhou, Jiangsu 213031 (CN)
(74) Representative: Maiwald GmbH
(86) International application number: PCT/CN2023/141378
(87) International publication number: WO 2024/187892

(57) **Abstract**

A photovoltaic cell pack, comprising at least four photovoltaic cells (1) successively arranged in a first direction (91). Lead-out sides (15) of the photovoltaic cells (1) have the same orientation; the lead-out side (15) of each photovoltaic cell (1) is provided with a plurality of electrodes (2); the electrode (2) on each photovoltaic cell (1) comprises a positive electrode (291) and a negative electrode (292); the electrodes (2) on the photovoltaic cells (1) adjacent to each other in the first direction (91) are connected by means of welding structures; the plurality of photovoltaic cells (1) successively arranged in the first direction (91) are connected in parallel to form a parallel group (19); adjacent parallel groups (19) in the first direction (91) are connected in series with each other.

## Description

### TECHNICAL FIELD

The present application belongs to the technical field of the photovoltaic module technology and relates to a photovoltaic cell pack and a manufacturing method therefor, and as well as photovoltaic module.

### BACKGROUND

When photovoltaic cells are assembled into larger photovoltaic modules (photovoltaic cell packs), it may lead to issues such as cell cracking, resulting in failure, reducing yield of photovoltaic modules, or it may result in higher costs, increased risk of short-circuit defects, and lower long-term reliability.

### SUMMARY

The present application provides a photovoltaic cell pack and a manufacturing method therefor, as well as a photovoltaic module.

A first aspect of the embodiments of the present application provides a photovoltaic cell pack. The photovoltaic cell pack comprises at least four photovoltaic cells successively arranged in a first direction; wherein lead-out sides of the photovoltaic cells face the same direction, each of the lead-out side of the photovoltaic cells is provided with multiple electrodes, each of the electrodes on the photovoltaic cells comprises a positive electrode and a negative electrode; in the first direction, the electrodes on adjacent photovoltaic cells are connected by welding structures; multiple photovoltaic cells successively arranged in the first direction are connected in parallel to form a parallel group, and adjacent parallel groups in the first direction are connected in series.

A second aspect of the embodiments of the present application provides a photovoltaic module. The photovoltaic module comprises the photovoltaic cell pack described above and an encapsulation structure, and the encapsulation structure encapsulates the photovoltaic cell pack.

A third aspect of the embodiments of the present application provides a method for manufacturing for the photovoltaic cell pack described above. The method comprises: providing multiple photovoltaic cells and welding electrodes on adjacent photovoltaic cells in a first direction to form a welding structure.

### BRIEF DESCRIPTION OF THE DRAWINGS

Figure 1 is a top-view structural schematic diagram of a photovoltaic module in the related art.
Figure 2 is a top-view structural schematic diagram of a photovoltaic cell pack according to an embodiment of the present application.
Figure 3 is a partial cross-sectional structural schematic diagram along line AA' in Figure 2 according to an embodiment of the present application.
Figure 4 is another top-view structural schematic diagram of a photovoltaic cell pack according to an embodiment of the present application.
Figure 5 is another top-view structural schematic diagram of a photovoltaic cell pack according to an embodiment of the present application.
Figure 6 is a flowchart of the method for manufacturing a photovoltaic cell pack according to an embodiment of the present application.

Reference numeral:
1, photovoltaic cell; 15, lead-out side; 19, parallel group; 2, electrode; 21, main electrode; 22, sub-electrode; 229, interdigitated structure; 291, positive electrode; 292, negative electrode; 4, welding strip; 5, connection structure; 91, first direction; 92, second direction.

### DETAILED DESCRIPTION

In order to better understand the technical solutions of the present application, the following detailed description is provided in conjunction with the accompanying drawings and specific embodiments.

It should be understood that the specific embodiments and drawings described herein are merely for the purpose of explaining the present application, and do not limit the scope of the present application.

It should be understood that, unless otherwise specified, the various embodiments and features of the present application can be combined with each other without conflict.

It should be understood that, for convenience of description, the accompanying drawings only show parts related to the embodiments of the present application, and parts unrelated to the embodiments of the present application are not shown in the drawings.

Interdigitated Back Contact (IBC) cells have both positive and negative electrodes (busbars) located on the back side (the side away from sunlight) of the photovoltaic cell. Therefore, the electrodes do not block sunlight, which can further increase the short-circuit current density of the cell and improve the conversion efficiency of the cell.

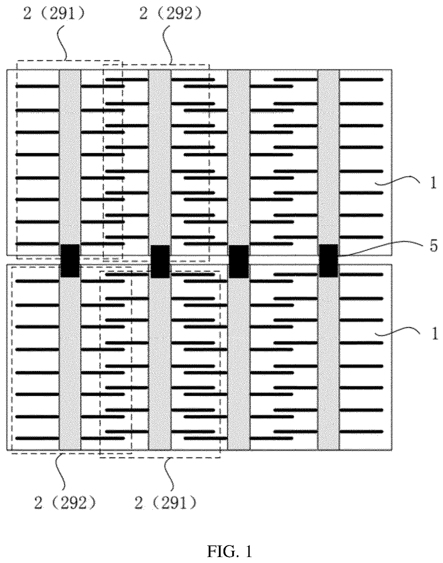

In some related technologies, as shown in Figure 1, the connection structures 5 can be formed by welding method or conductive adhesive bonding method to connect the electrodes 2 on different photovoltaic cells 1. Specifically, the positive electrode 291 of one photovoltaic cell 1 is connected to the negative electrode 292 of another photovoltaic cell 1. Therefore, multiple photovoltaic cells 1 are "connected in series" into a larger structure with greater output, that is, a "photovoltaic module (photovoltaic cell group)" is formed.

However, the heat generated during the welding process can cause warpage and deformation of the photovoltaic cells 1. In IBC cells, both the positive electrode 291 and the negative electrode 292 are on the same side of the photovoltaic cell 1. Therefore, the deformation caused by welding multiple electrodes 2 is "same direction", leading to more severe warpage of the photovoltaic cell 1.

Moreover, with the development of technology, the width (the dimension in the serial direction) of photovoltaic cells 1 is also increasing. That is, each photovoltaic cell 1 is a "large cell" with a larger width. The actual amount of the deformation of a "large cell" after welding is also greater due to warpage, which can easily lead to cell cracking and other issues during subsequent lamination and other processes, thereby causing failure and reducing the yield of photovoltaic modules.

Conductive adhesive bonding technology requires the use of conductive adhesive tape, and the cost of conductive tape is high. Moreover, due to the small spacing between different electrodes, it is easy to cause short circuit failure due to overflow of conductive adhesive. Additionally, based on the properties of conductive adhesive, its long-term reliability is also lower.

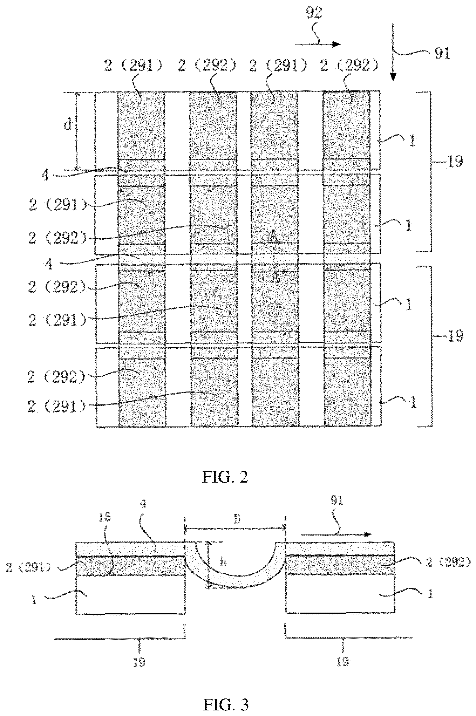

In first aspect, referring to Figures 2 to 5, the present application provides a photovoltaic cell pack.

Referring to Figure 2, the photovoltaic cell pack of the present application includes multiple photovoltaic cells 1.

Each photovoltaic cell 1 can generate electricity under sunlight, that is, a "small photovoltaic battery". In some embodiments, the photovoltaic cell 1 can be a crystalline silicon photovoltaic cell or any other form. Multiple photovoltaic cells 1 in the photovoltaic cell pack according to the embodiment of the present application are electrically connected to each other, to form a "large photovoltaic cell" with greater output. The "large photovoltaic cell" can be packaged to form a photovoltaic module. That is, the photovoltaic cell pack is the structure in the photovoltaic module that actually performs photoelectric conversion.

Referring to Figure 2, the photovoltaic cell pack of the embodiment of the present application includes at least four photovoltaic cells 1 successively arranged in a first direction 91; the lead-out sides 15 (referring to Figure 3) of the photovoltaic cell 1 face the same direction, and each of the lead-out side 15 of the photovoltaic cells 1 is provided with multiple electrodes 2, each of the electrodes 2 on the photovoltaic cells 1 comprises a positive electrode 291 and a negative electrode 292; in the first direction 91, the electrodes 2 on adjacent photovoltaic cells 1 are connected by welding structures (such as welding strips 4); multiple photovoltaic cells 1 successively arranged in the first direction 91 are connected in parallel to form a parallel group 19, and adjacent parallel groups 19 in the first direction 91 are connected in series.

Referring to Figure 2, the photovoltaic cell pack of the present application includes at least four photovoltaic cells 1 successively arranged in a first direction 91 (such as, longitudinal direction in FIG. 2). Each photovoltaic cell 1 is an approximately sheet-like structure, and one of its two main surfaces (the two equal surfaces with the largest areas) is the "lead-out side 15 (referring to Figure 3)" where the electrode 2 is provided. The lead-out sides 15 of each photovoltaic cell sheet 1 face the same direction. As shown in Figure 3, all of the lead-out sides 15 of the photovoltaic cells 1 are "upward".

The "lead-out side 15" can be the "back side (the side away from sunlight)", so that the electrodes 2 set on the lead-out side 15 will not block sunlight, which can further increase the short-circuit current density of the photovoltaic cell and improve the conversion efficiency of the cell.

Referring to Figure 2, the lead-out side 15 of each photovoltaic cell 1 is provided with multiple electrodes 2 (busbars) for extracting current. The electrode 2 on each photovoltaic cell 1 includes two types: the positive electrodes 291 and the negative electrodes 292; That is, each photovoltaic cell 1 includes both positive electrode 291 and negative electrode 292 on its lead-out side 15. Since the lead-out sides 15 of all photovoltaic cells 1 face the same direction, all electrodes 2 (including both positive 291 and negative 292 electrodes) of the photovoltaic cells 1 also face the same direction (as shown in Figure 2, all electrodes 2 are on the visible side of the photovoltaic cells 1).

Referring to Figure 2, in the second direction 92 (perpendicular to the first direction 91 as an example), the two types of electrodes 2 are alternately arranged, that is, the types of electrodes 2 in the second direction 92 alternate in the form of "positive electrode 291 - negative electrode 292 - positive electrode 291 ...".

Referring to Figure 2, in the first direction 91 (the longitudinal direction in Figure 2), adjacent photovoltaic cells 1 have multiple electrodes 2 respectively, and the electrodes 2 on different photovoltaic cells 1 are connected by welding structures (such as welding strips 4). Thus, multiple photovoltaic cells 1 arranged in the first direction 91 are connected to form a "cell string".

Referring to Figure 2, multiple (four in Figure 2 is taken as an example) photovoltaic cells 1 arranged in the first direction 91 are divided into multiple (two in Figure 2 is taken as an example) parallel groups 19, each parallel group 19 includes multiple (two in Figure 2 is taken as an example) photovoltaic cells 1 continuously arranged in the first direction 91.

In some embodiments of the present application, the screen used to prepare photovoltaic cells 1 can be divided into *N* (*N* being an even number greater than or equal to 4) electrode areas (one electrode area is one photovoltaic cells 1), and the original cell can be divided into *N* equal parts (i.e., *N* photovoltaic cells 1) by laser cutting. Every *N*/*2* parts (i.e., *N*/*2* photovoltaic cells 1) are connected in parallel to form a parallel group 19, and different parallel groups 19 are connected in series.

Referring to Figure 2, for multiple photovoltaic cells 1 of each parallel group 19, the same type of electrodes 2 are connected to each other, that is, the positive electrodes 291 of different photovoltaic cells 1 in the parallel group 19 are connected to each other, and the negative electrodes 292 of different photovoltaic cells 1 in the parallel group 19 are connected to each other; thereby achieving the effect of "parallel connection" of the photovoltaic cells 1 in the same parallel group 19. That is, each parallel group 19 is electrically equivalent to a "large cell".

Referring to Figure 2, between adjacent parallel groups 19 in the first direction 91, electrodes 2 of opposite types are connected to each other, that is, the positive electrode 291 of a photovoltaic cell 1 belonging to one parallel group 19 is connected to the negative electrode 292 of a photovoltaic cell 1 belonging to another parallel group 19; thereby achieving the effect of "series connection" between adjacent parallel groups 19 in the first direction 91. That is, the connection of different parallel groups 19 is electrically equivalent to the series connection of different "large cells".

Referring to Figure 2, the photovoltaic cell pack (photovoltaic module) of the present application adopts a connection method where photovoltaic cells 1 within a parallel group 19 are "connected in parallel", and different parallel groups 19 are "connected in series". Thus, the multiple photovoltaic cells 1 within a parallel group 19 are equivalent to a "large cell", and the series connection of different parallel groups 19 is equivalent to the series connection of different "large cells". Therefore, the photovoltaic cell pack of the present application is electrically equivalent to a series connection of multiple "large cells" with larger widths (the dimension in the first direction 91, denoted as d in Figure 2), but the width of each photovoltaic cell 1 is smaller than that of a "large cell".

In some embodiments, when the photovoltaic cell 1 is warped to the same degree (that is, the photovoltaic cell 1 have the same curvature) due to welding, the actual amount of the deformation is smaller when the width of the photovoltaic cell 1 is smaller. Therefore, it is not easy to cause cell cracking and other issues during subsequent lamination and other processes, thereby reducing the likelihood of failure and improving the yield of the photovoltaic module. Moreover, the present application uses welding connections instead of conductive adhesive bonding, thereby reducing the cost, reducing the risk of short-circuiting, and improving the long-term reliability.

In some embodiments, referring to Figure 2, the dimension of each photovoltaic cell 1 in the first direction 91 is between 10 mm and 100 mm.

In the present application, the width (the dimension in the first direction 91, denoted as d in Figure 2) of each photovoltaic cell 1 can specifically be between 10 mm and 100 mm. In some embodiments, the width of each photovoltaic cell 1 can be between 15 mm and 60 mm. In some embodiments, the width of each photovoltaic cell 1 can be between 20 mm and 40 mm. This range of width can ensure that the warpage deformation of the photovoltaic cell 1 can be acceptable, while this range of width can avoid the photovoltaic cell 1 being too small in size and too numerous in quantity.

In the present application, referring to Figure 2, the photovoltaic cells 1 have the same dimension in the first direction 91; and the number of photovoltaic cells 1 in each parallel group 19 is the same.

In some embodiments of the present application, referring to Figure 2, the widths of different photovoltaic cells 1 can be the same, and the number of photovoltaic cells 1 in different parallel groups 19 can be the same, the "large cells" equivalently formed by different parallel groups 19 also have the same size, which is conducive to uniform electrical performance.

It should be understood that, referring to Figure 2, considering neatness, the dimensions of different photovoltaic cells 1 in the second direction 92 can also be essentially the same.

In some embodiments, referring to Figure 2, the welding structure includes welding strips 4.

Referring to Figure 2, in some embodiments of the present application, welding strips 4 can specifically be used as the welding structure, that is, the welding strips 4 are welded to two electrodes 2 that need to be connected, thereby connecting the two electrodes 2 together.

Referring to Figure 2, in adjacent photovoltaic cells 1 in the first direction 91 (the longitudinal direction in Figure 2), the electrodes 2 that need to be connected by the welding structure (such as welding strips 4) can be in the same or similar position in the second direction 92 (the horizontal direction in Figure 2), or in other words, the electrodes 2 that need to be connected to each other can be "aligned" in the first direction 91. Thus, the welding strip 4 only needs to extend in the first direction 91 to connect different electrodes 2, thereby simplifying the structure.

The various specific parameters of the welding strip 4 can be selected as needed.

In some embodiments, the cross-section of the welding strip 4 can be circular, and the diameter of the circle is between 0.1 mm and 0.5 mm. In some embodiments, the cross-section of the welding strip 4 can also be rectangular, and the size of the rectangle is between (0.1 mm - 1.5 mm) × (0.1 mm - 0.5 mm).

In some embodiments, there is a gap between adjacent photovoltaic cells 1, and the welding strip 4 at the gap is curved.

In some embodiments of the present application, referring to Figure 2, there can be a gap between adjacent photovoltaic cells 1 in the first direction 91. Referring to Figure 3, the welding strip 4 at the gap (along the AA' line in Figure 2) is curved (such as "sagging"), thereby reducing the stress on the welding strip 4 and improving the thermal cycling performance of the photovoltaic cell pack.

The specific size of the gap can be selected as needed.

In some embodiments, referring to Figure 3, the size of the gap (the distance between adjacent photovoltaic cells 1, denoted as D in Figure 3) can be between 0.01 mm and 5 mm, and the height of the bent part of the welding strip 4 (the dimension in the direction perpendicular to the photovoltaic cell 1, denoted as *h* in Figure 3) can be between 10 µm and 1000 µm.

It should be understood that Figure 3 shows the structure at the gap (the AA' line in Figure 2) between adjacent parallel groups 19 in the first direction 91, so the types of electrodes 2 on the two photovoltaic cells 1 are different (one is the positive electrode 291 and the other is the negative electrode 292). For the gap between adjacent photovoltaic cells 1 within the same parallel group 19, the structure is similar to that shown in Figure 3, but the two electrodes 2 should be of the same type.

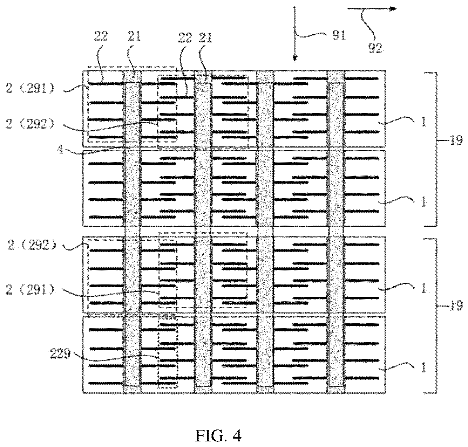

In some embodiments, referring to Figure 4, each electrode 2 includes a main electrode 21 extending in the first direction 91; the main electrodes 21 on adjacent photovoltaic cells 1 in the first direction 91 are connected by the welding structure (such as welding strips 4).

Referring to Figure 4, in some embodiments of the present application, each electrode 2 (positive 291 or negative 292) can include a main electrode 21 (main busbar) extending in the first direction 91; and the welding structure (such as welding strips 4) connects the main electrodes 21 on adjacent photovoltaic cells 1 to each other, thereby achieving the connection of the corresponding electrodes 2.

In some embodiments, referring to Figure 4, each electrode 2 further includes multiple sub-electrodes 22 extending in the second direction 92 and connected to the main electrode 21. The sub-electrodes 22 of the same electrode 2 is spaced apart in the first direction 91.

Referring to Figure 4, each main electrode 21 can also be connected to multiple sub-electrodes 22 (auxiliary busbars), and each sub-electrode 22 extends in the second direction 92 (the horizontal direction in Figure 4). The sub-electrodes 22 connected to the same main electrode 21 is spaced apart in the first direction 91 (the vertical direction in Figure 4). Therefore, carriers generated at various positions of the photovoltaic cell 1 can be uniformly collected through the sub-electrodes 22, and then carriers can be transmitted to the corresponding main electrode 21.

Referring to Figure 4, the photovoltaic cell 1 can be an Interdigitated Back Contact (IBC) cell. For two adjacent main electrodes 21 in the second direction 92, the ends of the sub-electrodes 22 connected to one main electrode 21 are inserted into the gaps between the sub-electrodes 22 connected to the other main electrode 21. So that an "interdigitated structure 229" (referring to the dotted line frame in Figure 4) is formed, to collect carriers more uniformly.

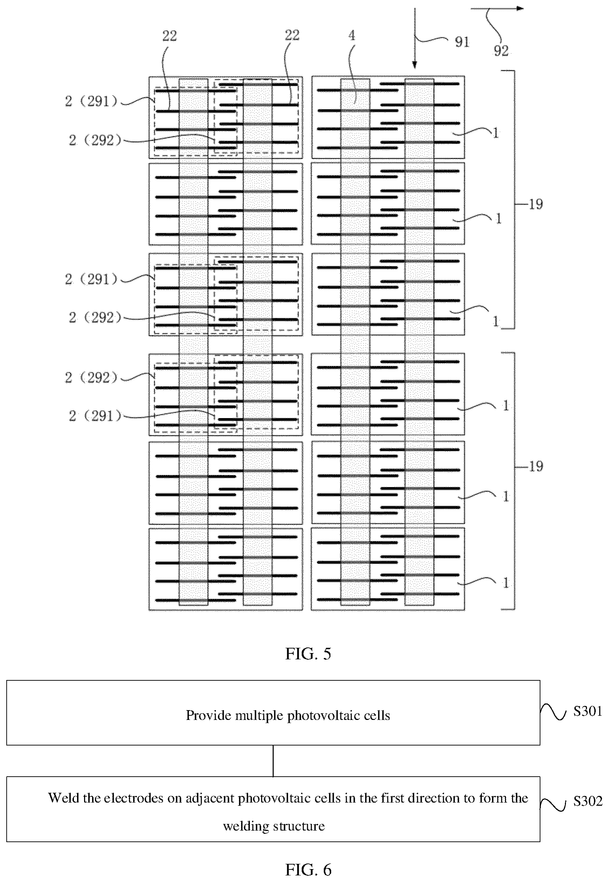

Referring to Figure 5, in another embodiment, each electrode 2 includes multiple sub-electrodes 22 extending in the second direction 92 and spaced apart in the first direction 91; all sub-electrodes 22 of the same electrode 2 are welded to the same welding strip 4.

Referring to Figure 5, in another embodiment of the present application, the electrode 2 (positive 291 or negative 292) may be "no" the main electrode, to simplify the structure of the product. Thus, each electrode 2 includes multiple independent sub-electrodes 22, and multiple sub-electrode 22 are spaced apart in the first direction 91.

Accordingly, referring to Figure 5, the multiple sub-electrodes 22 of the same electrode 2 (i.e., the multiple sub-electrodes 22 within a dotted line frame in Figure 5) are welded to the same welding strip 4. So that the welding strip 4 plays a similar role as the main electrode, to connect the different sub-electrodes 22 together.

Referring to Figure 5, when the structure without a main electrode is adopted, the welding strip 4 not only connects different parts of the same electrode 2 (different sub-electrodes 22) into a whole, but also connects the electrodes 2 on different photovoltaic cells 1 (i.e., different sub-electrodes 22).

It should be understood that the above description of the embodiments of the present application is merely illustrative and does not limit the scope of protection of the present application. The photovoltaic cell pack of the embodiments of the present application can also be in other forms.

In some embodiments, the number of electrodes 2 on each photovoltaic cell 1 can be four as shown in Figures 2 and 4, or two as shown in Figure 5, or other quantities.

In some embodiments, the number of photovoltaic cells 1 in each parallel group 19 can be two as shown in Figures 2 and 4, or three as shown in Figure 5, or other quantities.

In some embodiments, the number of parallel groups 19 in each cell string can be two as shown in Figures 2, 4, and 5, or other quantities.

In some embodiments, each photovoltaic cell pack can have only one cell string as shown in Figures 2 and 4, that is, only "one column" of photovoltaic cells 1 arranged in the first direction 91. In some embodiments, as shown in Figure 5, each photovoltaic cell pack can have multiple (two in the example of Figure 5) cell strings, that is, "multiple columns" of photovoltaic cells 1 arranged in the first direction 91, and different "columns" are arranged in the second direction 92. The electrodes 2 of photovoltaic cells 1 in different "columns" (i.e., photovoltaic cells 1 adjacent in the second direction 92) are not welded together, but can be connected through other structures (such as busbars), that is, busbars can connect different cell strings to each other.

In some embodiments, each welding structure (such as welding strip 4) can connect only two adjacent electrodes 2 in the first direction 91 as shown in Figure 2. In some embodiments, as shown in Figures 4 and 5, one welding strip 4 can cover multiple electrodes 2 arranged in the first direction 91, that is, each welding strip 4 connects multiple electrodes 2 together, thereby reducing the number of welding strips 4 used, simplifying the manufacturing process, while reducing resistance and improving connection strength.

In some embodiments, the welding structure can be in the form of welding strips 4 as shown in Figures 2 to 5. In some embodiments, the welding structure can also be in other forms, for example, different electrodes 2 on different photovoltaic cells 1 can be directly welded with solder, that is, the welding structure can also be solder.

In second aspect, referring to Figures 2 to 5, the present application provides a photovoltaic module. The photovoltaic module includes the photovoltaic cell pack described above; and an encapsulation structure that encapsulates the photovoltaic cell pack.

The above photovoltaic cell pack can be encapsulated with an encapsulation structure to form a relatively independent product, that is, a photovoltaic module.

The encapsulation structure can be in the form of encapsulation glass. For example, the above photovoltaic cell pack can be sandwiched between two photovoltaic glasses, to form a double-glass photovoltaic module.

It should be understood that a photovoltaic module can also include an adhesive film for fixing, a cable terminal for leading out the current generated by the photovoltaic cells 1, etc., which will not be described in detail here.

In third aspect, referring to Figures 2 to 6, the present application provides a method for manufacturing the photovoltaic cell pack described above.

Referring to Figure 6, the method for manufacturing the photovoltaic cell pack of the present application includes the following steps.

S301: Provide multiple photovoltaic cells 1.

S302: Weld the electrodes 2 on adjacent photovoltaic cells 1 in the first direction 91 to form the welding structure.

When the photovoltaic cell pack of the present application is manufactured, firstly, individual photovoltaic cells 1 are provided and arranged successively in the first direction 91, and then the welding structure is formed by welding (e.g., the welding strip 4 is placed on the electrodes 2 of adjacent photovoltaic cells 1 in the first direction 91, and then the welding strip 4 is welded to the electrodes 2 in contact with it), thereby connecting the electrodes 2 on adjacent photovoltaic cells 1 in the first direction 91.

It should be understood that the method of manufacturing the photovoltaic cell pack of the present application can also include other steps, such as the step for manufacturing individual photovoltaic cells 1 (e.g., directly manufacturing multiple photovoltaic cells 1, or manufacturing a large cell and then cutting it into multiple photovoltaic cells 1 by laser cutting, etc.).

It should be understood that when a photovoltaic module is manufactured, other steps such as lamination and encapsulation can be continued for the photovoltaic module, which will not be described in detail here.

It should be understood that the above implementation methods are merely illustrative examples for explaining the principles of the present application. However, the present application is not limited thereto. For those of ordinary skill in the art, various modifications and improvements can be made without departing from the spirit and essence of the present application, and these modifications and improvements are also considered within the scope of protection of the present application.

## Claims

1. A photovoltaic cell pack, **characterized by** comprising:
at least four photovoltaic cells (1) successively arranged in a first direction (91);
wherein lead-out sides (15) of the photovoltaic cells (1) face the same direction, each of the lead-out side (15) of the photovoltaic cells (1) is provided with multiple electrodes (2), each of the electrodes (2) on the photovoltaic cells (1) comprises a positive electrode (291) and a negative electrode (292);
in the first direction (91), the electrodes (2) on adjacent photovoltaic cells (1) are connected by welding structures;
multiple photovoltaic cells (1) successively arranged in the first direction (91) are connected in parallel to form a parallel group (19), and adjacent parallel groups (19) in the first direction (91) are connected in series.

2. The photovoltaic cell pack according to claim 1, wherein a dimension of each of the photovoltaic cells (1) in the first direction (91) is between 10 mm and 100 mm.

3. The photovoltaic cell pack according to claim 1, wherein the photovoltaic cells (1) have the same dimension in the first direction (91), and each of the parallel groups (19) comprises the same number of photovoltaic cells (1).

4. The photovoltaic cell pack according to claim 1, wherein each of the electrodes (2) comprises a main electrode (21) extending in the first direction (91);
and the main electrodes (21) on adjacent photovoltaic cells (1) in the first direction (91) are connected by the welding structures.

5. The photovoltaic cell pack according to claim 4, wherein each of the electrodes (2) further comprises multiple sub-electrodes (22) extending in a second direction (92) and connected to the main electrode (21); the sub-electrodes (22) of the same electrode are spaced apart in the first direction (91);
and the second direction (92) intersects with the first direction (91).

6. The photovoltaic cell pack according to claim 1, wherein the welding structures comprise welding strips (4).

7. The photovoltaic cell pack according to claim 6, wherein each of the electrodes (2) comprises multiple sub-electrodes (22) extending in a second direction (92) and spaced apart in the first direction (91); and the second direction (92) intersects with the first direction (91);
and all of the sub-electrodes (22) of the same electrode are welded to the same welding strip (4).

8. The photovoltaic cell pack according to claim 6, wherein there is a gap between adjacent photovoltaic cells (1) in the first direction (91), and the welding strip (4) at the gap is curved.

9. A photovoltaic module, **characterized by** comprising:
a photovoltaic cell pack according to any one of claims 1 to 8;
an encapsulation structure, encapsulating the photovoltaic cell pack.

10. A method for manufacturing a photovoltaic cell pack according to any one of claims 1 to 8, **characterized by** comprising:
providing multiple photovoltaic cells (1);
welding electrodes (2) on adjacent photovoltaic cells (1) in a first direction (91) to form a welding structure.
